# EUROPEAN PATENT APPLICATION

(11) **EP 4 293 888 A1**
(43) Date of publication of application: **20.12.2023**
(21) Application number: 23178790.4
(22) Date of filing: 12.06.2023
(51) Int. Cl.: H02M 1/32, H02M 1/36, H02M 7/02, G01R 19/00, H02J 7/00, H02J 7/02

(54) **AC-SIDE PRECHARGE ISOLATION DETECTION CIRCUIT AND AC-SIDE PRECHARGE CIRCUIT**

(30) Priority: 15.06.2022 CN 202210681867
(71) Applicant: Guangdong Carrier HVAC Co., Ltd., Foshan, Guangdong 528244 (CN)
(72) Inventor: FENG, Shanghua, Foshan, 528244 (CN); YI, Yulin, Foshan, 528244 (CN); YANG, Huandi, Foshan, 528244 (CN)
(74) Representative: Dehns

(57) **Abstract**

The present application discloses an AC-side precharge circuit. An AC-side precharge-isolation-detection circuit (100) is connected in parallel to both ends of the current limiting resistor (PTC) of the AC-side precharge circuit. The AC-side precharge-isolation-detection circuit (100) includes a step-down rectifier module (110), an optocoupler isolation module (120), and a voltage drop detection module (130), wherein the step-down rectifier module (100) is connected in parallel to the current limiting resistor (PTC) on the AC side, the input end of the optocoupler isolation module (120) is connected to the step-down rectifier module (110), and the output end of the optocoupler isolation module (120) is connected to the voltage drop detection module (130).

## Description

### TECHNICAL FIELD

The present invention belongs to the technical field of power supplies, and more particularly, relates to an AC-side precharge-isolation-detection circuit and an AC-side precharge circuit.

### BACKGROUND

Conventional precharge control decision is generally made by an MCU timer. After power is turned on, the power from an input side charges an electrolytic capacitor in a post-stage via a current limiting resistor PTC. When a delay time is reached, a relay is closed and the PTC is short circuited under an MCU output control signal, thereby completing the precharge. A fixed precharge time cannot perfectly match different input voltages. Frequent switching on and off will cause the current limiting resistor PTC to heat up, then the resistance value will increase, and the next precharge time will be prolonged. More frequent switching on and off will cause the PTC to be overheated, then the resistance value will be too large, and then the post-stage electrolytic capacitor cannot rise to the normal value. If the control is performed by relay short circuiting PTC at a fixed delay time, it will cause a large surge current, which will have a great impact on the relay and other components.

### SUMMARY

In the existing precharge, control is performed by relay short circuiting the PTC at a fixed delay time, which will cause a large surge current, and which will have a great impact on the relay and other components.

Embodiments of the present invention provide an AC-side precharge-isolation-detection circuit, which adopts the following technical solutions:

An AC-side precharge-isolation-detection circuit, including a step-down rectifier module, an optocoupler isolation module and a voltage drop detection module, wherein the step-down rectifier module is connected in parallel to both ends of a current limiting resistor of a precharge circuit, an input end of the optocoupler isolation module is connected to the step-down rectifier module, and an output end of the optocoupler isolation module is connected to the voltage drop detection module, wherein
the step-down rectifier module is configured for step-down and rectification of the detection circuit;
the optocoupler isolation module is configured to isolate the precharge circuit and the voltage drop detection module; and
the voltage drop detection module is configured to detect voltage drop change of the current limiting resistor of the precharge circuit.

Optionally, the step-down rectifier module includes a first current limiting resistor, a first diode and a second diode connected in series, one end of the first current limiting resistor is connected to a cathode of the first diode, an anode of the first diode is connected to an anode of the second diode, and the other end of the first current limiting resistor and a cathode of the second diode are both connected to the current limiting resistor of the precharge circuit.

Optionally, the voltage drop detection module includes a second current limiting resistor, and one end of the second current limiting resistor is connected to the output end of the optocoupler isolation module, the other end of the second current limiting resistor is grounded, and a common point of the second current limiting resistor and the output end of the optocoupler isolation module is used as a detection signal output end of the voltage drop detection module.

Optionally, the detection signal output end is connected to a sampling end of an MCU.

Optionally, the voltage drop detection module further includes a filter capacitor, and the filter capacitor is connected in parallel to the second current limiting resistor.

Optionally, the optocoupler isolation module includes a first optocoupler and a second optocoupler connected in parallel, and an input end of the first optocoupler and an input end of the second optocoupler are both connected to the step-down rectifier module, and an output end of the first optocoupler and an output end of the second optocoupler are connected to the voltage drop detection module.

Optionally, the input end of the first optocoupler is a first light emitting diode, and the output end of the first optocoupler is a first triode, an anode of the first light emitting diode is connected between one end of the first current limiting resistor and the cathode of the first diode, and a cathode of the first light emitting diode is connected between the anode of the first diode and the anode of the second diode, a collector of the first triode is connected to a power supply, and an emitter of the first triode is grounded via the second current limiting resistor; the input end of the second optocoupler is a second light emitting diode, and the output end of the second optocoupler is a second triode, an anode of the second light emitting diode is connected between the cathode of the second diode and the current limiting resistor of the precharge circuit, and a cathode of the second light emitting diode is connected between the anode of the first diode and the anode of the second diode, a collector of the second triode is connected to the power supply, and an emitter of the second triode is grounded via the second current limiting resistor.

Embodiments of the present invention additionally provide an AC-side precharge circuit, which adopts the following technical solutions:

An AC-side precharge circuit, including an input circuit, a power integrated module, and an electrolytic capacitor, the input circuit being connected to one side of the power integrated module, and the electrolytic capacitor being connected to the other side of the power integrated module, wherein the AC-side precharge circuit further includes the AC-side precharge-isolation-detection circuit described above, and the AC-side precharge-isolation-detection circuit is connected in parallel to a current limiting resistor of the input circuit.

Optionally, the input circuit is a three-phase input circuit, and the AC-side precharge-isolation-detection circuit is connected in parallel to the current limiting resistor of any one phase circuit of the three-phase input circuit.

Optionally, the AC-side precharge circuit further includes a relay, the relay being connected in parallel to the AC-side precharge-isolation-detection circuit.

Compared with the existing technology, the embodiments of this invention mainly have the following beneficial effects:

The AC-side precharge-isolation-detection circuit is connected in parallel to both ends of the current limiting resistor PTC of the AC-side precharge circuit. The AC-side precharge-isolation-detection circuit includes a step-down rectifier module, an optocoupler isolation module, and a voltage drop detection module, wherein the step-down rectifier module is connected in parallel to the current limiting resistor PTC on the AC side, the input end of the optocoupler isolation module is connected to the step-down rectifier module, and the output end of the optocoupler isolation module is connected to the voltage drop detection module. The present invention can realize isolation of operating voltages at the pre-stage input and the post-stage output for the AC-side precharge-isolation-detection circuit through the optocoupler, detect voltage drop change across the current limiting resistor PTC of the precharge circuit, and transfer a voltage drop output signal to the MCU for sampling to determine whether the precharge is completed, and can prevent a surge current.

### BRIEF DESCRIPTION OF THE DRAWINGS

In order to illustrate the solutions in the present invention more clearly, the following will briefly introduce the accompanying drawings used in the description of the embodiments of the present invention. For those of ordinary skill, other drawings can also be obtained from these drawings without any creative effort.
Fig. 1 shows a structural block diagram of an AC-side precharge-isolation-detection circuit;
FIG. 2 shows a schematic diagram of connection of the AC-side precharge-isolation-detection circuit;
Fig. 3 shows a schematic diagram of connection of a single-phase PFC circuit; and
FIG. 4 shows a schematic diagram of connection of three-phase Vienna topology PFC circuit.

### DETAILED DESCRIPTION

Unless otherwise defined, all technical and scientific terms used herein have the same meaning as commonly understood by one of ordinary skill in the technical field of this invention; the terms used herein in the specification are for the purpose of describing specific embodiments only. It is not intended to limit the present invention; the terms "comprising" and "having" and any variations thereof in the description and claims are intended to cover non-exclusive inclusion. The terms "first", "second" and the like in the description and claims are used to distinguish different objects, rather than to describe a specific order.

Reference herein to an "embodiment" means that a particular feature, structure, or characteristic described in connection with the embodiment can be included in at least one embodiment of the present invention. The appearances of the term in various places in the specification are not necessarily all referring to the same embodiment, nor a separate or alternative embodiment that is mutually exclusive with other embodiments. It is explicitly and implicitly understood by those skilled in the art that the embodiments described herein may be combined with other embodiments.

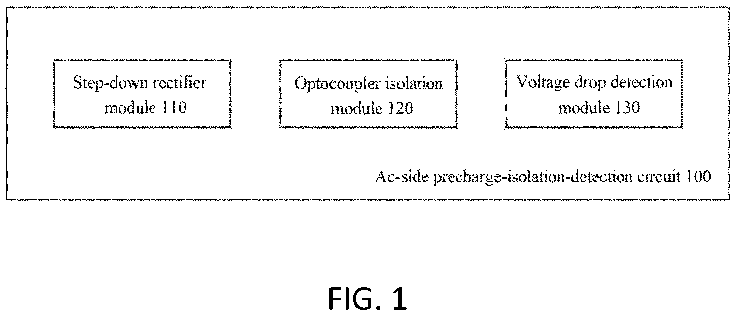

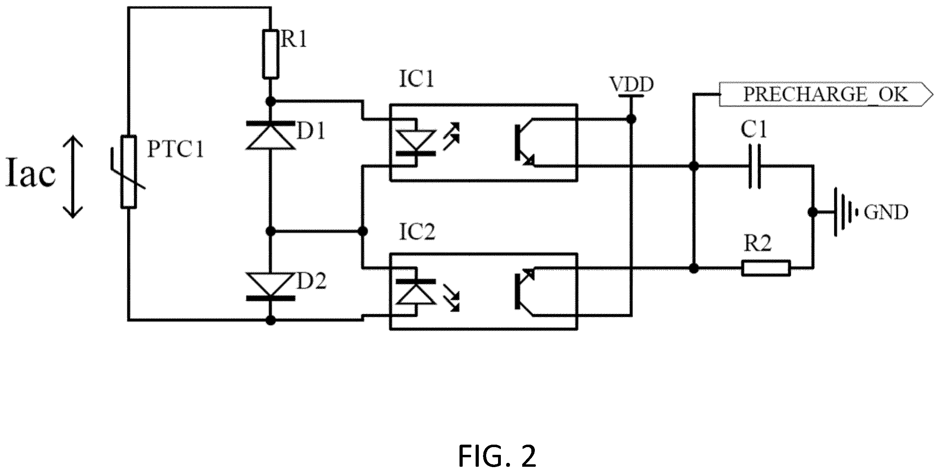

Referring to FIG. 1 and FIG. 2, an AC-side precharge-isolation-detection circuit 100 in this embodiment includes a step-down rectifier module 110, an optocoupler isolation module 120 and a voltage drop detection module 130. The step-down rectifier module 110 is connected in parallel to both ends of a current limiting resistor PTC of the precharge circuit. An input end of the optocoupler isolation module 120 is connected to the step-down rectifier module 110, an output end of the optocoupler isolation module 120 is connected to the voltage drop detection module 130, and the voltage drop detection module 130 is connected to a sampling end of an MCU. Here, the step-down rectifier module 110 is used for step-down and rectification of the detection circuit, the optocoupler isolation module 120 is used to isolate the precharge circuit and the voltage drop detection module 110, and the voltage drop detection module 130 is used to detect voltage drop change across the current limiting resistor PTC of the precharge circuit.

The above-mentioned embodiment can realize isolation of operating voltages at the pre-stage input and the post-stage output for the AC-side precharge-isolation-detection circuit 100 through the optocoupler, detect voltage drop change across the current limiting resistor PTC of the precharge circuit, and transfer a voltage drop output signal to the MCU for sampling to determine whether the precharge is completed, and can prevent a surge current.

Further, the step-down rectifier module 110 includes a first current limiting resistor R1, a first diode D1 and a second diode D2 connected in series. One end of the first current limiting resistor R1 is connected to the cathode of the first diode D1, the anode of the first diode D1 is connected to the anode of the second diode D2, and the other end of the first current limiting resistor R1 and the cathode of the second diode D2 are both connected to the current limiting resistor PTC of the precharge circuit, so that the step-down rectifier module 110 is connected to both ends of the current limiting resistor PTC of the precharge circuit in parallel.

Further, the voltage drop detection module 130 includes a second current limiting resistor R2. One end of the second current limiting resistor R2 is connected to the output end of the optocoupler isolation module 120, and the other end of the second current limiting resistor R2 is grounded. A common point of the second current limiting resistor R2 and the output end of the optocoupler isolation module 120 serves as a detection signal output end of the voltage drop detection module 130. The detection signal output end is connected to the sampling end of the MCU. During detection, the voltage drop output signal PRECHARGE_OK is transferred to the MCU for sampling via the detection signal output end of the voltage drop detection module 130.

Further, the voltage drop detection module 130 also includes a filter capacitor C1, and the filter capacitor C1 is connected in parallel to the second current limiting resistor R2. The precharge current Iac is similar to an AC sine wave signal, which is a signal whose magnitude varies with time. When the input sine wave is near zero-crossing point, the current Iac will become very small or even 0, but this does not mean that the precharge of the post-stage is completed at the moment. Therefore, in order to avoid misjudgment, a filter capacitor C1 is connected in parallel to both ends of the second current limiting resistor R2. The discharge speed of the second current limiting resistor R2 on the filter capacitor C1 is much lower than that of the input AC zero-crossing point switching. When the input AC sine wave signal is near zero-crossing point and the current Iac is very small or even 0 for a short period of time, the filter capacitor C1 maintains a relatively stable voltage signal, ensuring stable charging near the zero-crossing point of the AC sine wave signal.

Further, the optocoupler isolation module 120 includes a first optocoupler IC1 and a second optocoupler IC2 connected in parallel, the input end of the first optocoupler IC1 and the input end of the second optocoupler IC2 are both connected to the step-down rectifier module 110, and the output end of the first optocoupler IC1 and the output end of the second optocoupler IC2 are connected to the voltage drop detection module 130.

Further, the input end of the first optocoupler IC1 is a first light emitting diode, the output end of the first optocoupler IC1 is a first triode, and the anode of the first light emitting diode is connected between one end of the first current limiting resistor R1 and the cathode of the first diode D1, the cathode of the first light emitting diode is connected between the anode of the first diode D1 and the anode of the second diode D2. The collector of the first triode is connected to a power supply VDD, and the emitter of the first triode is grounded via the second current limiting resistor R2. The input end of the second optocoupler IC2 is a second light emitting diode, the output end of the second optocoupler IC2 is a second triode, and the anode of the second photodiode is connected between the cathode of the second diode D2 and the current limiting resistor PTC of the precharge circuit, and the cathode of the second light emitting diode is connected between the anode of the first diode D1 and the anode of the second diode D2. The collector of the second triode is connected to the power supply VDD, and the emitter of the second triode is grounded via the second current limiting resistor R2.

In a specific embodiment, when the input of the AC-side precharge circuit is a positive half cycle of a sine wave, the direction of the current Iac is from bottom to top, the voltage at the upper end of the current limiting resistor PTC is higher than that at the lower end, and Iac passes through the first current limiting resistor R1 to the first optocoupler IC1, flows to the second diode D2 and returns to the lower end of the PTC, forming a current loop. At this time, the first light emitting diode in IC1 has current flowing therethrough and emits light, leading to the conduction of the first triode in IC1. The conduction current flows from the power supply VDD through the first triode in IC1 to the second current limiting resistor R2, and flows to GND to form a current loop. A voltage drop output signal PRECHARGE_OK about whether the precharge is completed is sent to the AD sampling end of the MCU. It is determined whether the precharge is completed by sampling the voltage drop output signal PRECHARGE_OK via the AD sampling end of the MCU.

Here, the greater the voltage drop across the current limiting resistor PTC is, the stronger the conduction of the IC1 optocoupler will be, and the higher the voltage signal on the second current limiting resistor R2 will be. Iac is similar to an AC sine wave signal, which is a signal whose magnitude varies with time. When the input sine wave is near zero-crossing point, Iac will become very small or even 0, but this does not mean that the precharge of the post-stage is completed at this moment. Therefore, in order to avoid misjudgment, the filter capacitor C1 is connected in parallel to both ends of the second current limiting resistor R2. The discharge speed of the second current limiting resistor R2 on the filter capacitor C1 is much lower than that of the input AC zero-crossing point switching. When the input AC sine wave signal is near zero-crossing point and Iac is very small or even 0 for a short period of time, the filter capacitor C1 maintains a relatively stable voltage signal, ensuring stable charging near the zero-crossing point of the AC sine wave signal.

When the input of the AC-side precharge circuit is the negative half cycle of the sine wave, Iac passes through the second optocoupler IC2 and then passes to the first diode D1, and then returns to the upper end of the PTC through the first current limiting resistor R1 to form a current loop. At this time, the second light emitting diode in IC2 has current flowing therethrough and emits light, and then the second triode in IC2 is turned on, and the conduction current flows from the power supply VDD through the second triode in IC2 to the second current limiting resistor R2, and flows to GND to form a current loop. The voltage drop output signal PRECHARGE_OK about whether the precharge is completed is also sent to the AD sampling end of the MCU. It is determined whether the precharge is completed by sampling the voltage drop output signal PRECHARGE_OK via the AD sampling end of the MCU.

The above embodiments discloses an AC-side precharge-isolation-detection circuit, which can realize isolation of operating voltages at the pre-stage input and the post-stage output for the detection circuit through two optocouplers, detect voltage drop change across the current limiting resistor PTC of the precharge circuit, and transfer a voltage drop output signal to the MCU for sampling to determine whether the precharge is completed, and can prevent a surge current.

### Example 2

The AC-side precharge circuit in this embodiment includes an input circuit, a power integrated module, and an electrolytic capacitor. The input circuit is connected to one side of the power integrated module, and the electrolytic capacitor is connected to the other side of the power integrated module. It also includes the above-mentioned AC-side precharge-isolation-detection circuit. The AC-side precharge-isolation-detection circuit is connected in parallel to a current limiting resistor of the input circuit. The input circuit is a three-phase input circuit, and the AC-side precharge-isolation-detection circuit is connected in parallel to the current limiting resistor of any one phase circuit of the three-phase input circuit. The AC-side precharge circuit further includes a relay, and the relay is connected in parallel to the AC-side precharge-isolation-detection circuit.

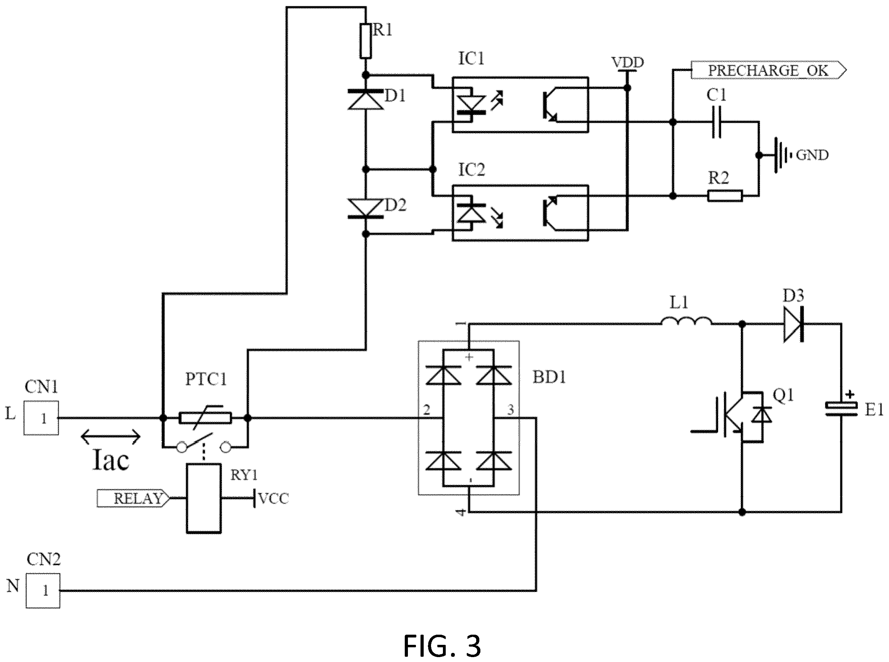

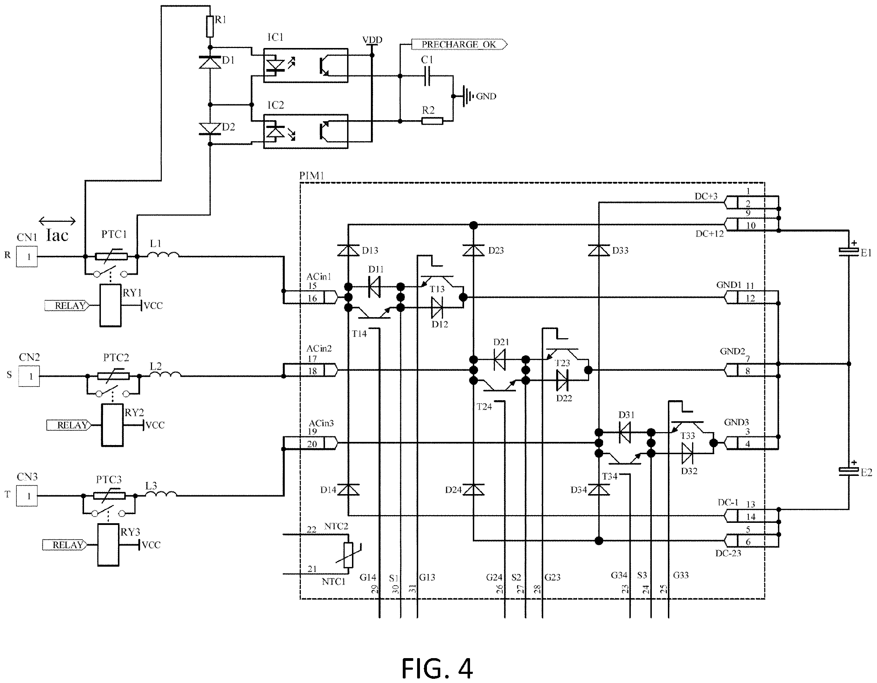

Referring to FIG. 3 and FIG. 4, the AC-side precharge-isolation-detection circuit can be applied to the precharge isolation detection of a three-phase Vienna topology PFC circuit, and can also be applied to the precharge isolation detection of a conventional single-phase PFC circuit. When the input circuit is a three-phase input circuit, the AC-side precharge-isolation-detection circuit is connected in parallel to the current limiting resistor of any one phase circuit of the three-phase input circuit.

Continuing to refer to FIG. 3, in a specific embodiment, during the precharge detection of the conventional single-phase PFC circuit, the input circuit is connected to a BD 1 module, and the BD1 module is then connected with an electrolytic capacitor E1, and the AC-side precharge-isolation-detection circuit is connected in parallel to a current limiting resistor PTC1 of the input circuit. The precharge current Iac of the positive and negative half cycles of the input sine wave is detected by the first optocoupler IC1 and the second optocoupler IC2 in a time sharing manner. When the voltage of the electrolytic capacitor E1 in the post-stage gradually rises and gradually approaches the highest value, the voltage drop across the current limiting resistor PTC1 gradually decreases, and finally drops to the lowest value. At this time, under the action of the first current limiting resistor R1, the driving current obtained by the light emitting diodes of IC1 and IC2 also gradually decreases to the lowest value. Due to the transmission characteristics of the optocoupling, the current of the post-stage power supply VDD flowing through the optocoupler also gradually decreases to the lowest value, and the voltage across the corresponding second current limiting resistor R2 also gradually decreases to the lowest value. Although the filter capacitor C1 has a certain maintenance effect on the voltage, but as the second current limiting resistor R2 continues to discharge to it, the final voltage will drop to the lowest value. During this process, the MCU continuously samples the voltage drop output signal PRECHARGE OK. When it is detected that it is lower than a preset value for t seconds, it determines that the precharge is completed, a relay control signal RELAY is outputted, and PTC1 is short circuited by the relay. At this time, the precharge control is completed.

Continuing to refer to FIG. 4, in another specific embodiment, during the precharge detection of the three-phase Vienna topology PFC circuit, the three-phase input circuit is connected to a PIM1 module, and the PIM1 module is then connected to the electrolytic capacitor E1 and the electrolytic capacitor E2. The AC-side precharge-isolation-detection circuit is connected in parallel to the current limiting resistor PTC1 of the R-phase circuit of the three-phase input circuit. The precharge current Iac of the positive and negative half cycles of the input sine wave is detected by the first optocoupler IC1 and the second optocoupler IC2 in a time sharing manner. When the voltage of the electrolytic capacitor E1 and the electrolytic capacitor E2 in the post-stage gradually rises and gradually approaches the highest value, the voltage drop across the current limiting resistor PTC1 gradually decreases, and finally drops to the lowest value. At this time, under the action of the first current limiting resistor R1, the driving current obtained by the light emitting diodes of IC1 and IC2 also gradually decreases to the lowest value. Due to the transmission characteristics of the optocoupling, the current of the post-stage power supply VDD flowing through the optocoupler also gradually decreases to the lowest value, and the voltage across the corresponding second current limiting resistor R2 also gradually decreases to the lowest value. Although the filter capacitor C1 has a certain maintenance effect on the voltage, but as the second current limiting resistor R2 continues to discharge to it, the final voltage will drop to the lowest value. During this process, the MCU continuously samples the voltage drop output signal PRECHARGE OK. When it is detected that it is lower than a preset value for t seconds, it determines that the precharge is completed, a relay control signal RELAY is outputted, and PTC1 is short circuited by the relay. At this time, the precharge control is completed.

The above embodiment discloses an AC-side precharge circuit, the AC-side precharge circuit may be a three-phase Vienna topology PFC circuit or a conventional single-phase PFC circuit, and the AC-side precharge circuit further includes the above-mentioned AC-side precharge-isolation-detection circuit. The AC-side precharge-isolation-detection circuit is connected in parallel to both ends of the current limiting resistor PTC of the AC-side precharge circuit. Embodiments of the present invention can realize isolation of operating voltages at the pre-stage input and the post-stage output for the AC-side precharge-isolation-detection circuit through the optocoupler, detect voltage drop change across the current limiting resistor PTC of the precharge circuit, and transfer a voltage drop output signal to the MCU for sampling to determine whether the precharge is completed, and can prevent a surge current.

Apparently, the above-described embodiments are only a part of the embodiments of the present invention, rather than all of the embodiments. The accompanying drawings show the preferred embodiments of the present invention, but do not limit the scope of the patent. The present invention may be embodied in many different forms, and these embodiments are provided so that a thorough and complete understanding of the disclosure of this invention is provided. Although the present invention has been described in detail with reference to the foregoing embodiments, those skilled in the art can still modify the technical solutions described in the foregoing specific embodiments, or perform equivalent replacements for some of the technical features therein within the scope of the invention, which is defined by the claims.

## Claims

1. An AC-side precharge-isolation-detection circuit (100), comprising a step-down rectifier module (110), an optocoupler isolation module (120) and a voltage drop detection module (130), wherein the step-down rectifier module (110) is configured to be connected in parallel to both ends of a current limiting resistor (PTC) of a precharge circuit, an input end of the optocoupler isolation module (120) is connected to the step-down rectifier module (110), and an output end of the optocoupler isolation module (120) is connected to the voltage drop detection module (130), wherein:
the step-down rectifier module (110) is configured for step-down and rectification of the detection circuit;
the optocoupler isolation module (120) is configured to isolate the precharge circuit and the voltage drop detection module (130); and
the voltage drop detection module (130) is configured to detect voltage drop change of the current limiting resistor (PTC) of the precharge circuit.

2. The AC-side precharge-isolation-detection circuit (100) according to claim 1, wherein:
the step-down rectifier module (110) comprises a first current limiting resistor (R1), a first diode (D1) and a second diode (D2) connected in series,
one end of the first current limiting resistor (R1) is connected to a cathode of the first diode (D1),
an anode of the first diode (D1) is connected to an anode of the second diode (D2), and
the other end of the first current limiting resistor (R1) and a cathode of the second diode (D2) are both configured to be connected to the current limiting resistor (PTC) of the precharge circuit.

3. The AC-side precharge-isolation-detection circuit (100) according to claim 2, wherein:
the voltage drop detection module (130) comprises a second current limiting resistor (R2),
one end of the second current limiting resistor (R2) is connected to the output end of the optocoupler isolation module (120),
the other end of the second current limiting resistor (R2) is grounded, and
a common point of the second current limiting resistor (R2) and the output end of the optocoupler isolation module (120) is used as a detection signal output end of the voltage drop detection module (130).

4. The AC-side precharge-isolation-detection circuit (100) according to claim 3, wherein the detection signal output end is connected to a sampling end of an MCU.

5. The AC-side precharge-isolation-detection circuit (100) according to claim 3 or 4, wherein the voltage drop detection module (130) further comprises a filter capacitor (C1), and the filter capacitor (C1) is connected in parallel to the second current limiting resistor (R2).

6. The AC-side precharge-isolation-detection circuit (100) according to claim 3, 4 or 5, wherein:
the optocoupler isolation module (120) comprises a first optocoupler (IC1) and a second optocoupler (IC2) connected in parallel,
an input end of the first optocoupler (IC1) and an input end of the second optocoupler (IC2) are both connected to the step-down rectifier module (110), and
an output end of the first optocoupler (IC1) and an output end of the second optocoupler (IC2) are connected to the voltage drop detection module (130).

7. The AC-side precharge-isolation-detection circuit (100) according to claim 6, wherein:
the input end of the first optocoupler (IC1) is a first light emitting diode, and the output end of the first optocoupler (IC1) is a first triode, an anode of the first light emitting diode is connected between one end of the first current limiting resistor (R1) and the cathode of the first diode (D1), a cathode of the first light emitting diode is connected between the anode of the first diode (D1) and the anode of the second diode (D2), a collector of the first triode is connected to a power supply (VDD), and an emitter of the first triode is grounded via the second current limiting resistor (R2); and
the input end of the second optocoupler (IC2) is a second light emitting diode, and the output end of the second optocoupler (IC2) is a second triode, an anode of the second light emitting diode is connected between the cathode of the second diode (D2) and the current limiting resistor (PTC) of the precharge circuit, a cathode of the second light emitting diode is connected between the anode of the first diode (D1) and the anode of the second diode (D2), a collector of the second triode is connected to the power supply (VDD), and an emitter of the second triode is grounded via the second current limiting resistor (R2).

8. An AC-side precharge circuit, comprising an input circuit, a power integrated module (BD1), and an electrolytic capacitor (E1), the input circuit being connected to one side of the power integrated module (BD1), and the electrolytic capacitor (E1) being connected to the other side of the power integrated module (BD1), wherein the AC-side precharge circuit further comprises the AC-side precharge-isolation-detection circuit (100) according to any one of claims 1 to 7, and the AC-side precharge-isolation-detection circuit (100) is connected in parallel to a current limiting resistor (PTC1) of the input circuit.

9. The AC-side precharge circuit according to claim 8, wherein the input circuit is a three-phase input circuit, and the AC-side precharge-isolation-detection circuit (100) is connected in parallel to the current limiting resistor (PTC1) of any one phase circuit of the three-phase input circuit.

10. The AC-side precharge circuit according to claim 8 or 9, further comprising a relay (RELAY), the relay (RELAY) being connected in parallel to the AC-side precharge-isolation-detection circuit (100).
